# EUROPÄISCHE PATENTSCHRIFT

(11) **EP 3 404 818 B1**
(45) Veröffentlichungstag und Bekanntmachung des Hinweises auf die Patenterteilung: **29.01.2020**
(21) Anmeldenummer: 17171087.4
(22) Anmeldetag: 15.05.2017
(51) Int. Cl.: H02M 7/00, H05K 7/20, H01L 23/538, H02M 1/088, H05K 7/14

(54) **HALBLEITERSCHALTANORDNUNG**
SEMICONDUCTOR CIRCUIT ASSEMBLY
DISPOSITIF DE SEMI-CONDUCTEURS

(43) Veröffentlichungstag der Anmeldung: 21.11.2018
(73) Patentinhaber: Siemens Mobility GmbH, 81739 München (DE)
(72) Erfinder: Henkel, Thomas, 91341 Röttenbach (DE); Lechler, Martin, 91056 Erlangen (DE); Nagel, Andreas, 90431 Nürnberg (DE)

(56) Entgegenhaltungen:
- EP-A1- 2 131 482
- CN-A- 101 826 837
- CN-A- 105 355 611
- CN-A- 106 505 876
- US-A1- 2012 205 983

## Beschreibung

Die Erfindung betrifft eine Halbleiterschaltanordnung mit mindestens zwei Halbbrückenmodulen, die jeweils einem Wechselspannungsanschluss aufweisen, einer positiven Gleichspannungsverschienung, einer negativen Gleichspannungsverschienung und mindestens einer Wechselspannungsverschienung. Ferner betrifft die Erfindung einen Stromrichter mit einer derartigen Halbleiterschaltanordnung sowie ein Fahrzeug mit mindestens einer derartigen Halbleiterschaltanordnung oder einem solchen Stromrichter.

Zur Steigerung der Leistungsfähigkeit von Stromrichtern, oder allgemein Schalteinrichtungen auf Basis von Halbleitern, wird eine Parallelschaltung von zwei oder mehr Halbleitern vorgenommen.

Die direkte, harte Parallelschaltung von Leistungshalbleitern zur Vergrößerung der Ausgangsleistung ist dabei eine übliche technische Lösung. Dabei ist eine möglichst gleichmäßige Belastung der Halbleiter wichtig. Dies wird erreicht durch
- eine Selektion der Halbleitereigenschaften (z.B. gleiche Durchlasskennlinie) und
- eine "symmetrische" Anordnung der Halbleiter.

Dabei sollen im folgenden Halbbrückenmodule betrachtet werden. Ein Halbbrückenmodul weist mindestens zwei in Reihe angeordnete Halbleiterschalter auf. Mit diesem Halbbrückenmodul kann eine Phase eines Stromrichters realisiert werden. Das Halbbrückenmodul weist dabei einen positiven Gleichspannungsanschluss zur Verbindung mit einer positiven Gleichspannungsverschienung, einen negativen Gleichspannungsanschluss zur Verbindung mit einer negativen Gleichspannungsverschienung und einen Wechselspannungsanschluss zur Verbindung mit einer Wechselspannungsverschienung. Die positive Gleichspannungsverschienung besitzt im Betrieb das positive Potential des Zwischenkreises und die negative Gleichspannungsverschienung besitzt im Betrieb das negative Potential des Zwischenkreises. Der Wechselspannungsanschluss stellt einen wechselspannungsseitigen Eingang oder Ausgang, beispielsweise eines Stromrichters, dar.

Halbbrückenmodule haben üblicherweise einen quaderförmigen Aufbau. Die Flächen haben dabei nicht unbedingt einen ebenen Aufbau. Sie können beliebig beschaffen sein. Die folgende Beschreibung dient dazu, die Seiten des Halbbrückenmoduls zu bezeichnen und so die Ausrichtung der Halbbrückenmodule zueinander beschreiben zu können.

Auf einer ersten Fläche, oftmals auch als Oberseite bezeichnet, befinden sich die entsprechenden Anschlüsse des Halbbrückenmoduls. Auf der gegenüberliegenden Seite kann das Halbbrückenmodul befestigt werden, vorzugsweise an einem Kühlkörper zum Abführen der im Betrieb entstehenden Wärme.

An die erste Fläche grenzen die vier Seitenflächen des Halbbrückenmoduls. Die beiden gegenüberliegenden Längsflächen erstrecken sich dabei im Wesentlichen parallel zu einer Verbindung von einem der Gleichspannungsanschlüsse zum Wechselspannungsanschluss. Die Seitenfläche, welche die beiden Längsflächen miteinander verbindet und näher zum Wechselspannungsanschluss liegt, wird als Wechselspannungsfläche bezeichnet.

Der Erfindung liegt die Aufgabe zugrunde eine Halbleiterschaltanordnung mit wechselspannungsseitig parallel angeordneten Halbbrückenmodulen anzugeben, bei der die Stromaufteilung auf die einzelnen Halbbrückenmodulen verbessert wird.

Die Aufgabe wird durch die Merkmale des Anspruchs 1 gelöst.

Vorteilhafte Ausgestaltungen der Erfindung sind in den abhängigen Ansprüchen angegeben.

Der Erfindung liegt die Erkenntnis zugrunde, dass sich die Stromaufteilung zwischen elektrisch parallel angeordneten Halbbrückenmodulen dadurch verbessern lässt, dass nicht nur die positive und negative Gleichspannungsverschienung sich über den Bereich erstreckt, in der sich die Wechselspannungsverschienung befindet, sondern auch die Hallbrückenmodule so anordnet, dass diese sich an ihrer Wechselspannungsfläche gegenüber liegen. Dadurch gleichen sich die Leiterschleifen, welche die Höhe der Induktivität für jedes Modul bestimmen, der einzelnen parallel angeordneten Halbbrückenmodule sich gegeneinander an. Dies bewirkt gerade für transiente Vorgänge eine gleichmäßige Aufteilung der Ströme auf die einzelnen parallelen Halbbrückenmodule. Je höher die Schaltfrequenz der Module ist, desto stärker wird sich dies aus. Anders ausgedrückt kann auch für hohe Schaltfrequenzen eine besonders gute gleichmäßige Aufteilung der Ströme auf die einzelnen Module erreicht werden.

Eine erste Verbesserung in der Stromaufteilung lässt sich dadurch erreichen, dass die DC-Zwischenkreisverschienung, also die positive Gleichspannungsverschienung DC+ und die negative Gleichspannungsverschienung DC- über die gesamte Anordnung zu vergrößern. Dadurch ist der Querschnitt der Stromschiene größer als er für die Stromstärker ausgelegt sein müsste. Durch die Vergrößerung in den Bereich der Wechselspannungsverschienung kann der Rückstrom des AC-Laststromes der Kontur der Wechselspannungsverschienung folgen (Proximity-Effekt). Bei dieser Anordnung ergeben sich nur minimale Induktivitätsunterschiede und damit eine weitgehend symmetrische Stromaufteilung.

Als besonders vorteilhaft hat es sich erwiesen, dass zumindest im Bereich der Wechselspannungsanschlüsse die Gleichspannungsverschienungen und die Wechselspannungsverschienung parallel zueinander angeordnet sind. Dabei sollten die Stromschienen einen Abstand zueinander haben, der ein Ladungsausgleich zwischen den Schienen verhindert (Isolationsabstand).

Durch die paarweise Anordnung der Halbbrückenmodule bei der die Wechselspannungsflächen sich benachbart gegenüberliegen kann eine besonders günstige Anordnung der Stromschienen realisiert werden. Es sind jeweils die Gleichspannungsanschlüsse, positiver wie auch negativer, und die Wechselspannungsanschlüsse mittels der positiven Gleichspannungsverschienung, der negativen Gleichspannungsverschienung und der Wechselspannungsverschienung miteinander zu verbinden. In dieser Ausrichtung der Halbbrückenmodule zeigen die Wechselspannungsanschlüsse zueinander und werden von der Wechselspannungsverschienung und der Zwischenkreisverschienung überdeckt.

Dies kann nun auf besonders einfache Weise geschehen. Dabei ist die Wechselspannungsverschienung die den Halbbrückenmodulen am nächsten liegende Verschienung. Die Wechselspannungsanschlüsse sind auch die Anschlüsse, die bei der Anordnung von zwei Halbbrückenmodulen die innersten Anschlüsse bilden. Die am zweitnächsten liegende Verschienung, also die vom Halbbrückenmodul hinter der Wechselspannungsverschienung folgt, ist diejenige, deren Anschlüsse neben den Wechselspannungsanschlüssen liegen. Die abschließende oder auch die von den Modulen entfernteste Verschienung bildet die Verschienung, die die äußeren Anschlüsse der parallel angeordneten Halbbrückenmodule miteinander verbindet.

Mit dieser Anordnung muss keine der Verschienungen eine andere durchdringen, um in Verbindung mit einem der Anschlüsse gebracht werden zu können. Dadurch wird ein gleichmäßiges induktives Verhalten für die einzelnen Halbbrückenmodule erreicht. Die Zwischenkreisverschienung kann dadurch besonders einfach ausgeführt werden. Ebenso ist die Montage einfach. Abstände zur Vermeidung von Überschlägen oder Kurzschlüssen sind auf einfache Weise durch die Abstände der Verschienungen einhaltbar. Somit entfallen aufwendige und fehleranfällige Montageschritte wie sie bei Löchern und Durchführungen erforderlich sind um vorgegebene Abstände sicher einzuhalten.

Bei einer vorteilhaften Ausgestaltung der Erfindung sind die Halbbrückenmodule jeweils paarweise derart angeordnet, dass die Wechselspannungsflächen zweier Halbbrückenmodule jeweils benachbart zueinander angeordnet sind.

Ein besonderer Vorteil im Aufbau der Halbleiterschaltanordnung besteht darin, dass sich damit sehr einfach verschiedenste Stromrichtervarianten realisieren lassen. Für die Realisierung eines Stromrichters sind häufig mehrere Phasen erforderlich, die durch unterschiedliche Wechselspannungsverschienungen gebildet werden. Dabei müssen nur die Lastanschlüsse verändert werden. Dies geschieht durch die Formgebung der Wechselspannungsverschienung. Übrige Komponenten des Leistungsteils des Stromrichters wie beispielsweise Zwischenkreisverschienung und Kühlkörper können bei unterschiedlichen Konfigurationen unverändert beibehalten werden. Dies erhöht die Anzahl der Gleichteile bei der Produktion unterschiedlicher Stromrichterkonfiguration und führt zu niedrigen Kosten in der Fertigung.

So können beispielsweise aus 12 Halbbrückenmodulen auf einfache Weise drei Phasen mit jeweils vier parallelen Halbbrückenmodulen erzeugt werden. Ebenso ist es möglich, zwei Phasen mit sechs parallelen Halbbrückenmodulen zu erzeugen. Dabei unterscheiden sich diese Anordnungen nur in der Ausbildung der entsprechenden Wechselspannungsverschienungen. Weitere Möglichkeiten sind beispielweise drei Phasen, 4-fach parallel oder sechs Phasen, 2-fach parallel. Somit können je nach Anzahl von Halbbrückenmodulen unterschiedliche Konfigurationen auf besonders einfache Weise allein durch Modifikation der Wechselspannungsverschienungen erzeugt werden.

Diese Ausgestaltung ist dann besonders vorteilhaft, wenn die Halbleiterschaltanordnung eine gerade Anzahl von Halbbrückenmodulen aufweist. Dann lassen sich alle vorhandenen Halbbrückenmodule paarweise gegenüber an ihrer Wechselspannungsfläche anordnen.

Eine mögliche Ausgestaltung ist, dass die Halbbrückenmodule kreisförmig angeordnet sind. Dabei liegen dann die Wechselspannungsflächen benachbart zueinander. Darüber hinaus liegen auch die der Wechselspannungsfläche gegenüberliegende Fläche des Halbbrückenmoduls benachbart zu der der Wechselspannungsfläche gegenüberliegende Fläche eines weiteren Halbbrückenmoduls.

Bei einer weiteren vorteilhaften Ausgestaltung der Erfindung sind die unterschiedlichen paarweise bezüglich ihrer Wechselspannungsflächen benachbart angeordneten Halbbrückenmodule bezüglich ihrer Längsfläche benachbart zueinander angeordnet. Damit lässt sich ein besonders kompakter Aufbau des Stromrichters bei hoher Flexibilität im Hinblick auf unterschiedliche Konfigurationen erzeugt werden. Da der Aufbau und die Anordnung sich nur in den Wechselspannungsverschienungen unterscheiden, kann mit dieser Anordnung ein hoch flexibler und gleichzeitig kompakter Aufbau für einen Stromrichter realisiert werden.

Bei einer weiteren vorteilhaften Ausgestaltung der Erfindung sind die positive Gleichspannungsverschienung und die negative Gleichspannungsverschienung durchdringungsfrei für die Verbindung mit den Halbbrückenmodulen zueinander angeordnet. Da die Anschlüsse spiegelbildlich zueinander angeordnet sind, können mit der Verschienung, die den Halbbrückenmodulen am nächsten angeordnet ist, die innersten Anschlüsse der Parallelschaltung miteinander verbunden werden. Darüber gestapelt sind die übrigen Verschienungen. Je höher die Schiene angeordnet ist, desto weiter liegt der Anschluss auf der Parallelschaltung der Halbbrückenmodule weiter außen. Die Stromschienen sind ohne Löcher oder Durchführungen für die Verbindung mit den Halbbrückenmodulen herstellbar. Dadurch ist die Montage nicht nur einfach sondern auch deutlich weniger fehleranfällig, da korrekte Abstände zwischen Durchführung und Loch zur Sicherstellung von Isolationsabständen nicht mehr erforderlich sind.

Bei einer weiteren vorteilhaften Ausgestaltung der Erfindung sind die Halbbrückenmodule auf einer Ebene, insbesondere auf einen Kühlkörper, montiert. Damit lässt sich auf einfache Weise eine bauliche Einheit für einen Stromrichter schaffen. Dieser ist auch aufgrund seines Gewichts einfach austauschbar. Gleichzeitig ist er universell für unterschiedliche Stromrichterkonfigurationen nutzbar. Das vereinfacht die Ersatzteilhaltung, was zu deutlich geringeren Kosten in der Logistik führt. Besonders vorteilhaft ist es, wenn als Ebene ein Kühlkörper gewählt wird. Dieser stellt dann die Kühlung von einer Vielzahl von Halbbrückenmodulen sicher. Gleichzeitig ist ein Kühlkörper derart verwindungssteif, eine Anordnung von mehreren Halbbrückenmodulen sicher und fest aufnehmen zu können.

Bei einer weiteren vorteilhaften Ausgestaltung der Erfindung sind die benachbarten Halbbrückenmodule parallel zueinander angeordnet. Mit der parallelen Anordnung können die Halbbrückenmodule besonders platzsparend angeordnet werden. Da auch die Befestigungsebene, beispielsweise ausgebildet als Kühlkörper, oftmals rechteckförmig ist, kann auch der Kühlkörper klein und kostengünstig ausgelegt werden.

Im Folgenden wird die Erfindung anhand der in den Figuren dargestellten Ausführungsbeispiele näher beschrieben und erläutert. Es zeigen:
- FIG 1, FIG 2: ein Halbbrückenmodul,
- FIG 3: Leiterschleifen bei parallel angeordneten Halbbrückenmodulen,
- FIG 4 bis FIG 9: Ausführungsbeispiele von Halbleiterschaltanordnungen und
- FIG 10: ein Schienenfahrzeug.

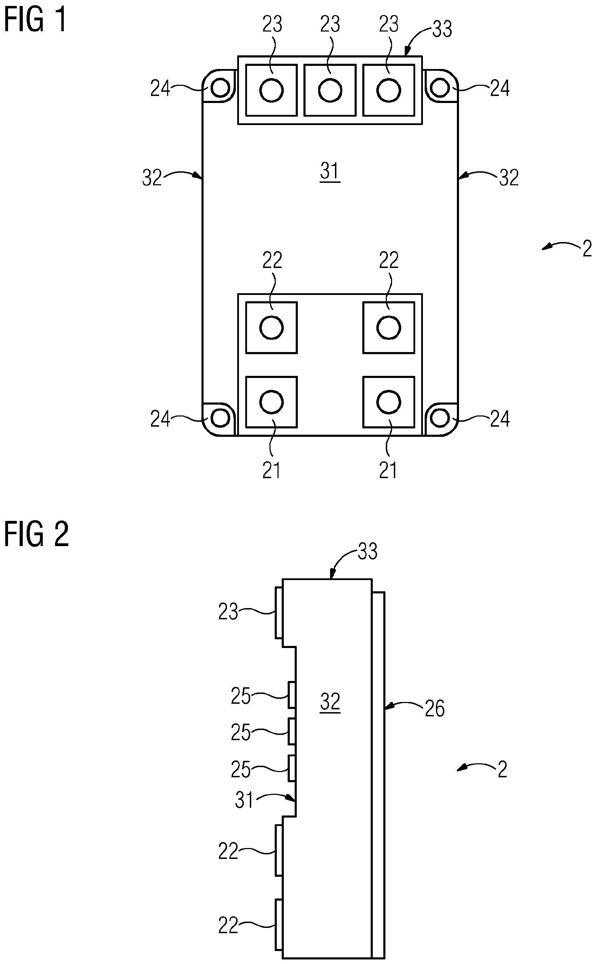

Die FIG 1 zeigt ein Halbbrückenmodul 2 mit seinen Gleichspannungsanschlüssen 21,22 und seinen Wechselspannungsanschlüssen 23. Diese dargestellte Seite bildet die erste Fläche 31 des quaderförmigen Halbbrückenmoduls 2. Zur Befestigung, beispielsweise an einem hier nicht dargestellten Kühlkörper 4, dienen die Bohrungen 24. Die Flächen, die sich im rechten Winkel an die erste Fläche 31 anschließen sind die Längsfläche 32 und die Wechselspannungsfläche 33. FIG 2 zeigt eine Seitenansicht des Halbbrückenmoduls 2. Zur Vermeidung von Wiederholungen wird auf die Beschreibung zur FIG 1 sowie auf die dort eingeführten Bezugszeichen verwiesen. Zusätzlich wird hier die Unterseite 26 dargestellt, an der das Halbbrückenmodul 2 vorzugsweise mit einem Kühlkörper 4 verbunden wird. Zur Ansteuerung der Schalter in dem Halbbrückenmodul 2 dienen die Steueranschlüsse 25.

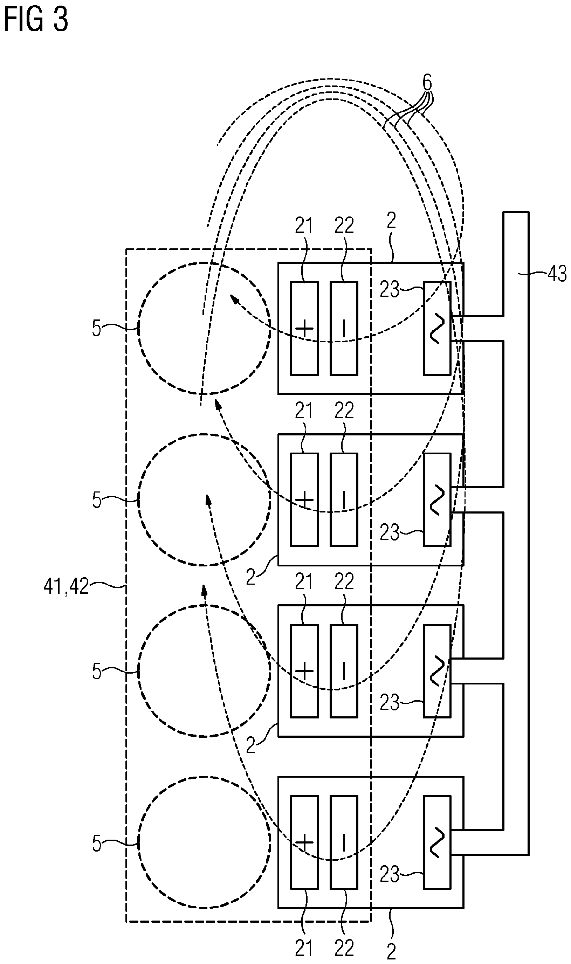

Anhand der FIG 3 lassen sich die unterschiedlichen Induktivitätsverhältnisse der vier Halbbrückenmodule 2 veranschaulichen. Dabei sind die Halbbrückenmodule 2 nebeneinander an ihrer Längsfläche 32 angeordnet. Zur Vermeidung von Wiederholungen wird auf die Beschreibung zu den Figuren 1 und 2 sowie auf die dort eingeführten Bezugszeichen verwiesen. Die einzelnen Anschlüsse sind mit Stromschienen verbunden. Für die Verbindung mit dem Kondensator 5 stehen die positive Gleichspannungsverschienung 41 und die negative Gleichspannungsverschienung 42 zur Verfügung, die übereinander angeordnet sind. Die nicht dargestellte elektrische Last wird mit der Wechselspannungsverschienung 43 verbunden. Der Kommutierungskreis schließt sich über die Last. Es ist zu erkennen, dass sich daraus für die Halbbrückenmodul 2 jeweils unterschiedliche Leiterschleifen 6 ergeben, die zu unterschiedlichen Induktivitäten führen. Diese bewirken teilweise recht hohe Stromunsymmetrien bei der Stromaufteilung auf die unterschiedlichen Halbbrückenmodule 2.

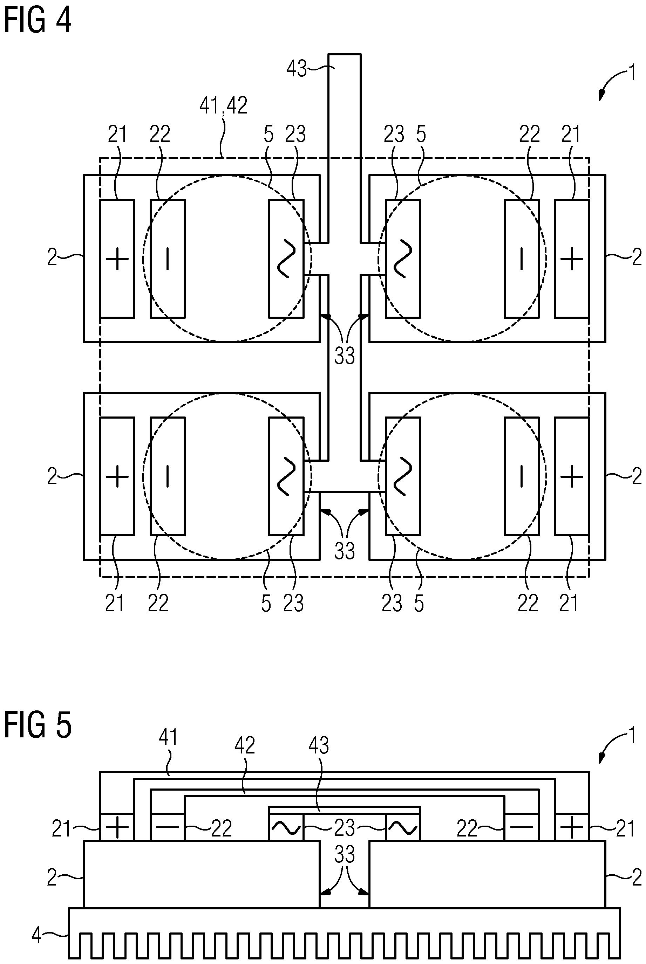

Die FIG 4 zeigt ein Ausführungsbeispiel einer Halbleiterschaltanordnung 1. Dabei sind die Halbbrückenmodule 2 paarweise so angeordnet, dass die Wechselspannungsflächen 33 benachbart sind. Darüber hinaus erstrecken sich die positive Gleichspannungsverschienung 41 und die negative Gleichspannungsverschienung 42 auch über den Bereich der Wechselspannungsanschlüsse 23, insbesondere auch über die Wechselspannungsverschienung 43 im Bereich der Wechselspannungsanschlüsse 23. Durch diesen Aufbau sind die Induktivitäten der einzelnen Kommutierungskreise gleich oder zumindest nahezu gleich groß, so dass sich eine gleichmäßige Stromaufteilung auf die elektrisch parallel angeordneten Halbbrückenmodule ergibt. Die FIG 5 zeigt eine Seitenansicht des Ausführungsbeispiels nach FIG 4. Zur Vermeidung von Wiederholungen wird auf die Beschreibung zur FIG 4 sowie auf die dort eingeführten Bezugszeichen verwiesen. Zur Kühlung und zur mechanischen Befestigung der Halbleiterschaltanordnung 1 dient der Kühlkörper 4. Durch die Ausrichtung, bei der die Wechselspannungsflächen 33 benachbart gegenüber liegen, ergibt sich eine günstige Anordnung der Anschlüsse 21, 22, 23. Diese Anschlüsse sind mittels Verschienungen 41, 42, 43 verbindbar, ohne dass hierfür eine der anderen Verschienungen 41, 42, 43 durchdrungen werden muss. Damit ist die Verbindung der einzelnen Anschlüsse nicht nur einfach und fehlerfrei durchführbar, sondern auch die Verschienungen 41, 42, 43 können aufgrund fehlender Durchführungen einfach und kostengünstig hergestellt werden.

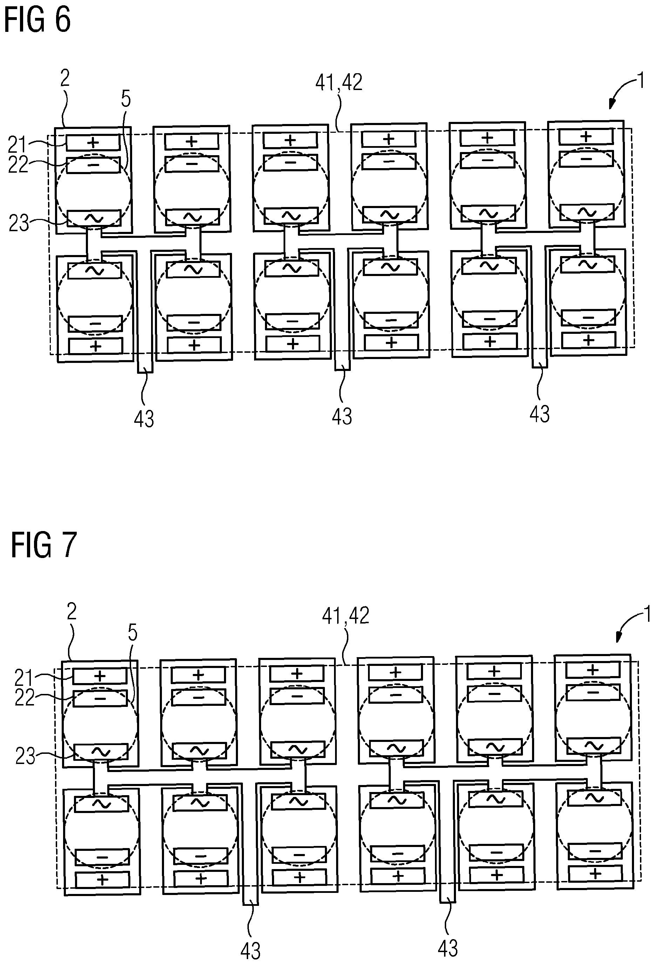

Die folgenden Figuren 6 bis 9 zeigen Ausführungsbeispiele, wie die Halbleiterschaltanordnung 1 beispielsweise zum Aufbau eines Stromrichters 3 ausgebildet sein kann. Es ist anzumerken, dass für alle diese Ausführungsbeispiele die 12 Halbbrückenmodule 2 gleich angeordnet sind und sich nur durch die Wechselspannungsverschienung 43 unterscheiden. Dies zeigt, dass diese Halbleiterschaltanordnung 1 modular einsetzbar ist und unterschiedliche Konfigurationen auf einfache Weise realisiert werden können. Dabei können neben der hier dargestellten Anzahl von 12 Halbbrückenmodulen auch jede andere beliebige Anzahl von Halbbrückenmodulen angeordnet werden. Besonders vorteilhaft ist eine durch 2 teilbare Anzahl von Halbbrückenmodulen 2, da dann zwei Halbbrückenmodule jeweils paarweise an ihren Wechselspannungsflächen benachbart gegenüber angeordnet werden können.

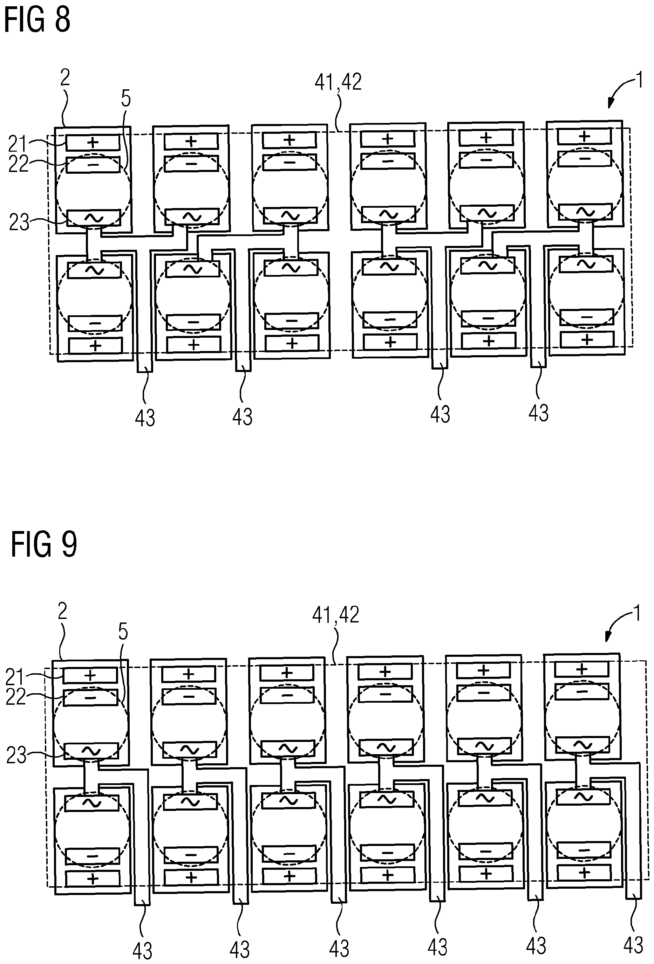

Die FIG 6 zeigt ein Ausführungsbeispiel mit drei Phasen und einer 4-fach Parallelschaltung. Die FIG 7 zeigt ein Ausführungsbeispiel mit zwei Phasen und einer 6-fach Parallelschaltung. Die FIG 8 zeigt ein Ausführungsbeispiel mit vier Phasen und einer 3-fach Parallelschaltung. Die FIG 9 zeigt ein Ausführungsbeispiel mit sechs Phasen und einer 2-fach Parallelschaltung.

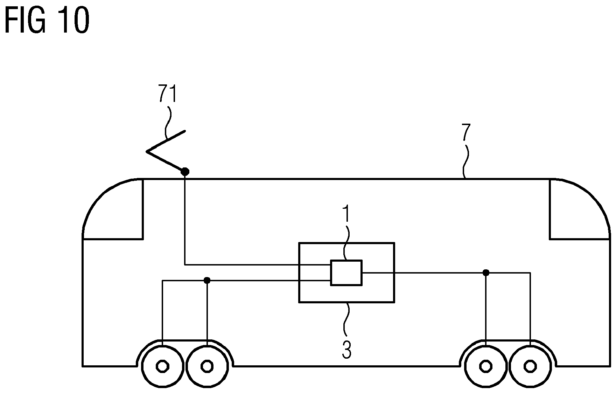

Die FIG 10 zeigt ein Fahrzeug 7, bei dem es sich um ein Schienenfahrzeug handelt. In dem Fahrzeug 7 ist ein Stromrichter 3 mit einer Halbleiterschaltanordnung 1 angeordnet. Der Stromrichter 3 dient dazu, die Motoren des Fahrzeugs 7 geregelt mit elektrischer Energie zu versorgen. Die dafür notwendige Energie bezieht das Fahrzeug 7 mittels eines Stromabnehmers 71 aus einem hier nicht dargestellten Fahrdraht.

Zusammenfassend betrifft die Erfindung eine Halbleiterschaltanordnung mit mindestens zwei Halbbrückenmodulen, die jeweils einen Wechselspannungsanschluss aufweisen und einer positiven Gleichspannungsverschienung, einer negativen Gleichspannungsverschienung und mindestens einer Wechselspannungsverschienung, wobei die Wechselspannungsanschlüsse elektrisch mittels der Wechselspannungsverschienung miteinander verbunden sind. Zur Verbesserung der Stromaufteilung auf diese elektrisch parallel angeordneten Halbbrückenmodule wird vorgeschlagen, dass sich zumindest im Bereich der Wechselspannungsanschlüsse die positive Gleichspannungsverschienung und die negative Gleichspannungsverschienung über einen Bereich erstrecken, in der die Wechselspannungsverschienung angeordnet ist, wobei zwei der mindestens zwei Halbbrückenmodule derart nebeneinander angeordnet sind, dass die Wechselspannungsflächen der zwei der mindestens zwei Halbbrückenmodule benachbart zueinander angeordnet sind. Ferner betrifft die Erfindung einen Stromrichter, mit mindestens einer derartigen Halbleiterschaltanordnung. Weiter betrifft die Erfindung ein Fahrzeug, insbesondere ein Schienenfahrzeug, mit mindestens einer solchen Halbleiterschaltanordnung oder einem solchen Stromrichter.

## Patentansprüche

1. Halbleiterschaltanordnung (1), aufweisend
- mindestens zwei Halbbrückenmodule (2) mit jeweils einem Wechselspannungsanschluss (23), einem negativen Gleichspannungsanschluss (22) und einem positiven Gleichspannungsanschluss (21), wobei jedes Halbbrückenmodul (2) zwei gegenüberliegende Längsflächen (32), die sich im Wesentlichen parallel zu einer Verbindung von einem der Gleichspannungsanschlüsse (21, 22) zum Wechselspannungsanschluss (23) erstrecken, und zwei gegenüberliegende Seitenflächen, von denen eine näher zum Wechselspannungsanschluss (23) liegt und eine Wechselspannungsfläche (33) bildet, aufweist;
- eine positive Gleichspannungsverschienung (41), eine negative Gleichspannungsverschienung (42) und mindestens eine Wechselspannungsverschienung (43),
wobei die Wechselspannungsanschlüsse (23) elektrisch mittels der Wechselspannungsverschienung (43) miteinander verbunden sind,
wobei sich zumindest im Bereich der Wechselspannungsanschlüsse (23) die positive Gleichspannungsverschienung (41) und die negative Gleichspannungsverschienung (42) über einen Bereich erstrecken, in dem die Wechselspannungsverschienung (43) angeordnet ist,
wobei zwei der mindestens zwei Halbbrückenmodule (2) derart nebeneinander angeordnet sind, dass die Wechselspannungsflächen (33) benachbart zueinander angeordnet sind, sich an ihrer jeweiligen Wechselspannungsfläche (33) gegenüber liegen und die Wechselspannungsanschlüsse (23) die innersten Anschlüsse bilden,
wobei die Wechselspannungsverschienung (43) eine den Halbbrückenmodulen (2) am nächsten liegende Verschienung bildet und die positive (41) und die negative Gleichspannungsverschienung (42) abhängig von der Anordnung der Gleichspannungsanschlüsse (21, 22) der Halbbrückenmodule (2) relativ zu den Wechselspannungsanschlüssen (23) die zu dem Halbbrückenmodul (2) zweitnächste bzw. entferntest liegende Verschienung bilden, und
wobei die Wechselspannungsverschienung (43) sowie die positive (41) und die negative Gleichspannungsverschienung (42) für die Verbindung mit den jeweiligen Anschlüssen (23, 22, 21) der Halbbrückenmodule (2) durchdringungsfrei zueinander angeordnet sind.

2. Halbleiterschaltanordnung (1) nach Anspruch 1, wobei die Halbbrückenmodule (2) jeweils paarweise derart angeordnet sind, dass die Wechselspannungsflächen (33) zweier Halbbrückenmodule (2) jeweils benachbart zueinander angeordnet sind.

3. Halbleiterschaltanordnung (1) nach Anspruch 2, wobei die unterschiedlichen paarweise bezüglich ihrer Wechselspannungsflächen (33) benachbart angeordneten Halbbrückenmodule (2) bezüglich ihrer Längsfläche (32) benachbart zueinander angeordnet sind.

4. Halbleiterschaltanordnung (1) nach einem der Ansprüche 1 bis 3, wobei die Halbbrückenmodule (2) auf einer Ebene, insbesondere auf einen Kühlkörper (4), montiert sind.

5. Halbleiterschaltanordnung (1) nach einem der Ansprüche 1 bis 4, wobei die benachbarten Halbbrückenmodule (2) parallel zueinander angeordnet sind.

6. Stromrichter (3), mit mindestens einer Halbleiterschaltanordnung (1) nach einem der Ansprüche 1 bis 5.

7. Fahrzeug (7), insbesondere Schienenfahrzeug, mit mindestens einer Halbleiterschaltanordnung (1) nach einem der Ansprüche 1 bis 5 oder einem Stromrichter (3) nach Anspruch 6.

## Claims

1. Semiconductor switching arrangement (1), having
- at least two half-bridge modules (2) that each have an AC voltage connection (23), a negative DC voltage connection (22) and a positive DC voltage connection (21), wherein each half-bridge module (2) has two opposing longitudinal surfaces (32) which extend substantially parallel to a connection from one of the DC voltage connections (21, 22) to the alternating voltage connection (23), and two opposing lateral surfaces, of which one is closer to the AC voltage connection (23) and forms an AC voltage surface (33);
- a positive DC voltage busbar (41), a negative DC voltage busbar (42) and at least one AC voltage busbar (43),
wherein the AC voltage connections (23) are electrically interconnected by means of the AC voltage busbar (43), wherein at least in the region of the AC voltage connections (23), the positive DC voltage busbar (41) and the negative DC voltage busbar (42) extend over an area containing the AC voltage busbar (43),
wherein two of the at least two half-bridge modules (2) are arranged adjacently such that the AC voltage surfaces (33) are arranged spatially adjacently in relation to one other, oppose their respective AC voltage surface (33) and the AC voltage connections (23) form the innermost connections,
wherein the AC voltage busbar (43) forms a busbar arranged closest to the half-bridge modules (2) and the positive (41) and the negative DC voltage busbar (42) form the busbar which is second closest to or furthest from the half-bridge module (2) as a function of the arrangement of the DC voltage connections (21, 22) of the half-bridge module (2) relative to the AC voltage connections (23), and
wherein the AC voltage busbar (43) and the positive (41) and
the negative DC voltage busbar (42) for the connection with the respective connections (23, 22, 21) of the half-bridge module (2) are arranged in a penetration-free manner in relation to one another.

2. Semiconductor switching arrangement (1) according to claim 1, wherein the half-bridge modules (2) are each arranged in pairs in such a way that the AC voltage surfaces (33) of two half-bridge modules (2) are each arranged spatially adjacently in relation to one other.

3. Semiconductor switching arrangement (1) according to claim 2, wherein the different half-bridge modules (2) adjacently arranged in pairs with regard to their AC voltage surfaces (33) are arranged spatially adjacently in relation to one other with regard to their longitudinal surface (32).

4. Semiconductor switching arrangement (1) according to one of claims 1 to 3, wherein the half-bridge modules (2) are mounted on a plane, particularly on a heat sink (4).

5. Semiconductor switching arrangement (1) according to one of claims 1 to 4, wherein the adjacent half-bridge modules (2) are arranged parallel to one other.

6. Converter (3), having at least one semiconductor switching arrangement (1) according to one of claims 1 to 5.

7. Vehicle (7), particularly a rail vehicle, having at least one semiconductor switching arrangement (1) according to one of claims 1 to 5 or a converter (3) according to claim 6.

## Revendications

1. Circuit (1) à semiconducteur, comportant
au moins deux modules (2) à demi pont, ayant chacun une borne (23) de tension alternative, une borne (22) négative de tension continue et une borne (21) positive de tension continue, chaque module (2) à semiconducteur ayant deux surfaces (32) longitudinales opposées, qui sont sensiblement parallèles à une liaison de l'une des bornes (21, 22) de tension continue à la borne (23) de tension alternative, et deux surfaces latérales opposées, dont l'une est plus près de la borne (23) de tension alternative et forme une surface (33) de tension alternative ;
une barrette (41) positive de tension continue, une barrette (42) négative de tension continue et au moins une barrette (43) de tension alternative,
dans lequel les bornes (23) de tension alternative sont connectées entre elles électriquement au moyen de la barrette (43) de tension alternative,
dans lequel, au moins dans la région, des bornes (23) de tension alternative, la barrette (41) positive de tension continue et la barrette (42) négative de tension continue s'étendent sur une région, dans laquelle la barrette (43) de tension alternative est disposée,
dans lequel deux des au moins deux modules (2) en demi pont sont disposés l'un à côté de l'autre, de manière à ce que les surfaces (33) de tension alternative soient disposées au voisinage l'une de l'autre, soient opposées sur leur surface (33) respective de tension alternative et, de manière à ce que les bornes (23) de tension alternative forment les bornes les plus à l'intérieur,
dans lequel la barrette (43) de tension alternative forme une barrette se trouvant le plus près des modules (2) à demi pont et la barrette (41) positive et la barrette (42) négative de tension continue forment, en fonction de la disposition des bornes (21, 22) de tension continue des modules (2) en demi pont par rapport aux bornes (23) de tension alternative, la barrette se trouvant en deuxième la plus proche ou la plus loin du module (2) à demi pont, et dans lequel la barrette (43) de tension alternative, ainsi que la barrette (41) positive et la barrette (42) négative de tension continue sont, pour la liaison avec les bornes (23, 22, 21) respectives des modules (2) à demi pont, disposées les unes par rapport aux autres, sans pénétration.

2. Circuit (1) à semiconducteur suivant la revendication 1, dans lequel les modules (2) à demi pont sont disposés chacun par paire, de manière à ce que les surfaces (33) de tension alternative de deux modules (2) à demi pont soient, respectivement, voisines l'une de l'autre.

3. Circuit (1) à semiconducteur suivant la revendication 2, dans lequel les modules (2) à demi pont différents, disposés par paire en ayant leur surface (33) de tension alternative voisines, sont disposés au voisinage l'un de l'autre en ce qui concerne leur surface (32) longitudinale.

4. Circuit (1) à semiconducteur suivant l'une des revendications 1 à 3, dans lequel les modules (2) à demi pont sont montés sur un plan, notamment sur un puits (4) de chaleur.

5. Circuit (1) à semiconducteur suivant l'une des revendications 1 à 4, dans lequel les modules (2) à demi pont voisins sont disposés parallèlement l'un à l'autre.

6. Convertisseur (3), ayant au moins un circuit (1) à semiconducteur suivant l'une des revendications 1 à 5.

7. Véhicule (7), notamment véhicule ferroviaire, ayant au moins un circuit (1) à semiconducteur suivant l'une des revendications 1 à 5 ou un convertisseur (3) suivant la revendication 6.
